(19) Europäisches Patentamt
European Patent Office
Office européen des brevets

(11) **EP 0 738 883 B1**

(12) **EUROPÄISCHE PATENTSCHRIFT**

(45) Veröffentlichungstag und Bekanntmachung des Hinweises auf die Patenterteilung:
**27.11.2002 Patentblatt 2002/48**

(51) Int Cl.7: **G01H 11/08**, H03G 3/00

(21) Anmeldenummer: **96105227.1**

(22) Anmeldetag: **01.04.1996**

(54) **Ultraschallwandlerkopf mit integrierten steuerbaren Verstärkereinrichtungen**

Ultrasonic transducer with integrated controllable amplifier

Transducteur à ultrason intégré avec un amplificateur réglable

(84) Benannte Vertragsstaaten:
**DE DK ES FR**

(30) Priorität: **18.04.1995 DE 19514308**

(43) Veröffentlichungstag der Anmeldung:
**23.10.1996 Patentblatt 1996/43**

(73) Patentinhaber: **intelligeNDT Systems & Services GmbH & Co. KG**
**91058 Erlangen (DE)**

(72) Erfinder: **Oppelt, Ralph, Dr.**
**91080 Uttenreuth (DE)**

(74) Vertreter: **Mörtel & Höfner**
**Patentanwälte**
**Blumenstrasse 1**
**90402 Nürnberg (DE)**

(56) Entgegenhaltungen:
**EP-A- 0 287 443**     **EP-A- 0 600 654**
**GB-A- 1 587 106**     **US-A- 4 140 107**
**US-A- 4 445 379**

**Beschreibung**

Die Erfindung bezieht sich auf einen Ultraschallwandlerkopf und ein Ultraschallgerät mit einem solchen Wandlerkopf. Der Ultraschallwandlerkopf umfaßt wenigstens ein Wandlerelement, das Ultraschallsignale empfängt und in elektrische Empfangssignale umwandelt, sowie eine Verstärkereinrichtung, die die Empfangssignale des Wandlerelements elektrisch verstärkt. Ein solcher Ultraschallwandlerkopf ist aus der EP-A-0 600 654 bekannt.

Es sind Ultraschallgeräte zum Abbilden von Objekten mit Ultraschall mit Hilfe der Puls-Echo-Methode bekannt, die hauptsächlich in der Medizin zum Abbilden von Gewebe und in der zerstörungsfreien Werkstoffprüfung eingesetzt werden. Bei diesen bekannten Ultraschallgeräten wird ein Wandlerkopf (Applikator) über das abzubildende Objekt geführt. Der Wandlerkopf enthält wenigstens ein piezoelektrisches Wandlerelement, im allgemeinen jedoch eine Vielzahl von Wandlerelementen, die ein lineares oder zweidimensionales Array bilden. Die Wandlerelemente im Wandlerkopf werden in einem Sendebetrieb des Ultraschallgeräts durch elektrische Sendepulse eines Senders zu hochfrequenten Schwingungen angeregt und erzeugen einen auf das Objekt gerichteten Ultraschallpuls. Dieser Ultraschallpuls wird in dem Objekt beispielsweise an Grenzflächen zwischen zwei Medien unterschiedlicher akustischer Impedanz reflektiert. In einem Empfangsbetrieb des Systems werden die zum Wandlerkopf zurückreflektierten Ultraschall-Echopulse von den Wandlerelementen in entsprechende elektrische Empfangssignale umgewandelt. Diese Empfangssignale werden vom Wandlerkopf über entsprechende Signalkabel zu einem Hauptgerät (main frame) übertragen. Im Hauptgerät werden die übertragenen Empfangssignale jedes Wandlerelements von einem diesem Wandlerelement zugeordneten Vorverstärker verstärkt. Die verstärkten Empfangssignale werden einer Signalverarbeitungseinheit im Hauptgerät zum Auswerten der Informationen über das abgebildete Objekt zugeführt.

Ein Problem bei solchen Ultraschallgeräten ist die hohe Dynamik der Empfangssignale während des Empfangsbetriebs. Zu Beginn des Empfangsbetriebs sind die Signalamplituden der empfangenen Echopulse noch vergleichsweise hoch, nehmen dann aber wegen der Dämpfung innerhalb des Objekts mit zunehmender Dauer des Empfangsbetriebs immer mehr ab. Zum Ausgleich der durch die Dämpfung im Objekt bewirkte Signalabschwächung werden im allgemeinen im Hauptgerät steuerbare Verstärker mit einer laufzeitabhängig gesteuerten Verstärkung (Time-gaincompensation-amplifiers = TGC amplifiers) vorgesehen. Ein derartiges Hauptgerät wird beispielsweise in der US-A-4,445,379 beschrieben.

Ein weiteres Problem stellen die Impedanzunterschiede zwischen den vergleichsweise hochohmigen Wandlerelementen und den niederohmigen Signalkabeln und die daraus resultierende Belastung der Wandlerelemente als Signalquellen dar. Zur besseren Impedanzanpassung ist aus *US-A-4,489,729* bekannt, im Wandlerkopf für jedes Wandlerelement einen linearen Vorverstärker mit fest eingestellter Verstärkung zu integrieren. Dieser bekannte lineare Vorverstärker enthält einen Operationsverstärker, dessen Ausgang mit einem Eingang über eine Parallelschaltung aus einem Festwiderstand einerseits und einer Reihenschaltung zweier Kondensatoren andererseits (Tiefpaßschaltung) rückgekoppelt ist. Stellt man die konstante Verstärkung solcher Vorverstärker klein ein, so ist der Signal-Rausch-Abstand für schwache Empfangssignale entsprechend klein. Bei großer konstanter Verstärkung der Vorverstärker können dagegen hohe Empfangssignalamplituden verzerrt werden. Bei Verwendung eines Vorverstärkers mit fest eingestellter Verstärkung ist deshalb der Dynamikbereich des Ultraschallgeräts vergleichsweise klein.

Aus *EP-A-0 600 654* ist ein Ultraschallgerät zum Abbilden eines Objekts bekannt, bei dem jedem Wandlerelement im Wandlerkopf zusätzlich zu einem Vorverstärker mit konstanter Verstärkung ein Verstärker mit steuerbarer Verstärkung (variable gain amplifier) zugeordnet ist. Der Vorverstärker mit fest vorgegebener Verstärkung ist elektrisch zwischen das Wandlerelement und den steuerbaren Verstärker geschaltet. Der Ausgang des steuerbaren Verstärkers ist mit einem Gegentaktemitterfolger als Impedanzwandler gebildet und ist mit dem zugehörigen Signalkabel elektrisch verbunden, das die verstärkten Empfangssignale zu einem Hauptgerät überträgt. Die Eingangsimpedanz des Vorverstärkers ist der hohen Impedanz des Wandlerelements angepaßt, während die Ausgangsimpedanz des Gegentaktemitterfolgers der niedrigeren Impedanz des Signalkabels angepaßt ist. Im Hauptgerät werden die verstärkten Empfangssignale zum Aufbau eines Bildes des Objekts herangezogen. Der steuerbare Verstärker wird vom Hauptgerät über zusätzliche Leitungen im Signalkabel mit Steuersignalen (TGC control signals) zum Steuern der Verstärkung des steuerbaren Verstärkers angesteuert, um laufzeitabhängige Dämpfungen zu kompensieren. Bei diesem bekannten Ultraschallgerat sind somit die steuerbaren Kompensationsverstärker (TGC amplifiers) im Wandlerkopf integriert.

Die steuerbaren Verstärker in diesem aus *EP-A-0 600 654* bekannten Wandlerkopf funktionieren nach dem Prinzip eines Steilheitsmultiplizierers, der beispielsweise aus *Tietze, Schenk: "Halbleiterschaltungstechnik", 9. Auflage, 1990, Springer Verlag, S. 350* bekannt ist. Der Ruhestrom der gesamten Schaltung muß so bemessen sein, daß auch das Ultraschallempfangssignal mit der höchsten Amplitude verzerrungsfrei übertragen wird. Die steuerbaren Verstärker beim aus *EP-A-0 600 654* bekannten Ultraschallgerät weisen daher eine vergleichsweise hohe Verlustleistung auf.

Es ist ein Operationsverstärker mit einer steuerbaren Verstärkung bekannt, bei dem ein von einer kontinuierlich oder digital steuerbaren Steuerspannungsquelle steuerbarer Feldeffekttransistor (FET) in eine Gegenkopplungsschaltung für den Operationsverstärker geschaltet ist. Für den FET als steuerbaren Widerstand ist zusätzlich eine Rückkopplungsschaltung mit einem weiteren Operationsverstärker zum Linearisieren des elektrischen Widerstandes des FET vorgesehen. Auch kann der FET mit einer Gegenkopplung zum Vergrößern seines Dynamikbereichs beschaltet sein (*"Application Note 200-1, Designer's Guide for 200 Series Op Amps" der Firma Comlinear Corporation, November 1984*). FETs als steuerbare Widerstände benötigen zwar keine Steuerleistung, weisen jedoch vergleichsweise hohe Toleranzen in ihren Kennlinien auf.

Bei zweidimensionalen Arrays von Ultraschallwandlerelementen ist eine große Anzahl (typischerweise 5000) von Vorverstärkern in dem Wandlerkopf in einem deutlich kleineren Volumen zu integrieren als bei eindimensionalen Arrays. Der Leistungsverbrauch der Vorverstärker muß deshalb im allgemeinen deutlich kleiner sein als bei einem eindimensionalen Array, um eine Überhitzung zu vermeiden. Aus dem gleichen Grund stellt auch die Verlustleistung der integrierten Verstärker in einem aus der genannten *EP-A-0 600 654* bekannten Ultraschallwandlerkopf ein Problem dar.

Der Erfindung liegt deshalb die Aufgabe zugrunde, einen Ultraschallwandlerkopf mit wenigstens einem Wandlerelement und mit einer steuerbaren Verstärkereinrichtung für jedes Wandlerelement sowie ein Ultraschallgerät mit einem solchen Wandlerkopf anzugeben, bei denen die Verstärkung jeder Verstärkereinrichtung steuerbar ist und zugleich die Verlustleistung jeder Verstärkereinrichtung geringgehalten wird. Bei einem eindimensionalen oder zweidimensionalen Array von Wandlerelementen im Wandlerkopf sollen die den Wandlerelementen jeweils zugeordneten Verstärkereinrichtungen außerdem gute Gleichlaufeigenschaften aufweisen.

Diese Aufgabe wird gemäß der Erfindung gelöst mit den Merkmalen des Anspruchs 1 bzw. des Anspruchs 12.

Die Erfindung beruht auf der Überlegung, die Verstärkung der Verstärkereinrichtung durch Steuern einer Kapazität zu steuern. Eine solche kapazitive Steuerung weist einen praktisch vernachlässigbaren Stromverbrauch auf. Die Verstärkereinrichtung enthält ausgehend von dieser Überlegung wenigstens ein kapazitives Bauelement, dessen Kapazität steuerbar ist und die Verstärkung der Verstärkereinrichtung bestimmt.

Ausgestaltungen und Weiterbildungen des Ultraschallwandlerkopfs und des Ultraschallgeräts gemäß der Erfindung ergeben sich aus den vom Anspruch 1 bzw. vom Anspruch 12 jeweils abhängigen Ansprüchen.

Als steuerbares kapazitives Bauelement ist vorzugsweise eine Kapazitätsdiode vorgesehen. Kapazitätsdioden sind über eine in Sperrichtung angelegte Steuerspannung praktisch verlustleistungsfrei steuerbar und weisen genau reproduzierbare Kennlinien auf.

In einer vorteilhaften Ausführungsform ist das wenigstens eine kapazitive Bauelement in eine Gegenkopplungsschaltung für wenigstens einen Verstärker geschaltet.

Eine besonders vorteilhafte Ausführungsform beruht auf der weiteren Überlegung, das elektrische Empfangssignal des Wandlerelements in der Verstärkereinrichtung nacheinander zwei Übertragungsgliedern mit unterschiedlich frequenzabhängigen Übertragungsfunktionen zuzuführen und die beiden Übertragungsfunktionen dabei so zu wählen oder so einzustellen, daß sich ihre Frequenzabhängigkeiten in einem vorgegebenen Frequenzbereich der Empfangssignale im wesentlichen kompensieren und die Amplitude des verstärkten Ausgangssignals der Verstärkereinrichtung gegenüber der Amplitude des Eingangssignals eine im wesentlichen frequenzunabhängige Verstärkung aufweist. Die Verstärkung für das elektrische Empfangssignal wird dann durch Verändern der Frequenzabhängigkeit der beiden Übertragungsfunktionen in dem vorgegebenen Frequenzbereich gesteuert. Aufbauend auf dieser Überlegung enthält die Verstärkereinrichtung in dieser Ausführungsform zwei elektrische Übertragungsglieder mit jeweils einer frequenzabhängigen Übertragungsfunktion. Die Übertragungsfunktion ist dabei definiert als Verhältnis der Amplitude des Ausgangssignal zur Amplitude des Eingangssignals des jeweiligen Übertragungsglieds. Die beiden Übertragungsglieder sind zwischen einen Eingang der Verstärkereinrichtung zum Anlegen des zu verstärkenden elektrischen Empfangssignals und einen Ausgang der Verstärkereinrichtung zum Abgreifen des verstärkten elektrischen Empfangssignals in Reihe geschaltet. Wenigstens eines der beiden Übertragungsglieder enthält das wenigstens eine steuerbare kapazitive Bauelement. Die Frequenzabhängigkeiten der Übertragungsfunktionen der beiden Übertragungsglieder sind so gewählt, daß die beiden entsprechenden logarithmischen Übertragungsfunktionen im Bereich jeweils einer Flanke im wesentlichen linear abhängig von einer bijektiven Funktion der Frequenz sind. Die logarithmische Übertragungsfunktion ist dabei proportional zum Logarithmus des Betrags der im allgemeinen komplexen Übertragungsfunktion zu einer vorgegebenen reellen Basis. Die logarithmische Übertragungsfunktion eines der beiden Übertragungsglieder weist eine positive Flanke mit einer positiven Steigung auf, während die logarithmische Übertragungsfunktion des anderen Übertragungsglieds eine negative Flanke aufweist mit einer negativen Steigung. Die Steigungen der beiden Flanken der logarithmischen Übertragungsfunktionen sind betragsmäßig wenigstens annähernd gleich gewählt. Die Flanken der beiden logarithmischen Übertragungsfunktionen sind nun relativ zueinander innerhalb des Frequenzbereichs der Empfangssignale verschiebbar. Durch Verschieben der Flanken gegeneinander wird die Verstärkung der Verstärkereinrichtung gesteuert.

Das Ultraschallgerät enthält dazu Steuermittel, die wenigstens mit dem Übertragungsglied, das das kapazitive Bauelement enthält, in Wirkverbindung stehen. Die Steuermittel können nur eine Flanke zu kleineren oder größeren Frequenzen hin verschieben, während die andere Flanke unverändert bleibt, oder auch beide Flanken zugleich verschieben.

Das Übertragungsglied mit der positiven Flanke (Flanke mit positiver Steigung) kann wenigstens ein Element aus der einen Hochpaß wenigstens erster Ordnung, einen Differentiator und ein Preemphasisglied umfassenden Gruppe von elektrischen Schaltungen oder Netzwerken enthalten. Das Übertragungsglied mit der negativen Flanke (Flanke mit negativer Steigung) kann wenigstens ein Element aus der einen Tiefpaß wenigstens erster Ordnung, einen Integrator und ein Deemphasisglied umfassenden Gruppe von elektrischen Schaltungen oder Netzwerken enthalten. Solche Übertragungsglieder können insbesondere mit gegengekoppelten Verstärkern realisiert werden.

Zur weiteren Erläuterung der Erfindung wird auf die Zeichnung Bezug genommen, in deren

| | |
|---|---|
| FIG 1 | ein Ultraschallwandlerkopf in einem prinzipiellen Aufbau |
| FIG 2 | ein Ultraschallgerat mit einem Wandlerkopf in einem prinzipiellen Aufbau |
| FIG 3 | eine Verstärkereinrichtung im Wandlerkopf mit einem gegengekoppelten Verstärker |
| FIG 4 | ein prinzipieller Aufbau einer Verstärkereinrichtung im Wandlerkopf mit zwei Übertragungsgliedern, |
| FIG 5 | eine typische Abhängigkeit der Verstärkung der Verstärkereinrichtung von der Frequenz der Empfangssignale in einem Diagramm, |
| FIG 6 bis 8 | jeweils ein Ausführungsbeispiel zum Verschieben der Flanken der Übertragungsfunktionen der beiden Übertragungsglieder der Verstärkereinrichtung, |
| FIG 9 bis 11 | jeweils eine Ausführungsform eines Übertragungsglieds mit positiver Flanke, |
| FIG 12 bis 14 | jeweils eine Ausführungsform eines Übertragungsglieds mit negativer Flanke |
| FIG 15 | eine Ausführungsform eines Übertragungsglieds mit zwei steuerbaren Kapazitätsdioden |
| FIG 16 | eine Ausführungsform einer Verstärkereinrichtung im Wandlerkopf mit zwei besonderen Übertragungsgliedern und gemeinsamen Steuermitteln |

jeweils schematisch dargestellt sind. Einander entsprechende Teile sind mit denselben Bezugszeichen versehen.

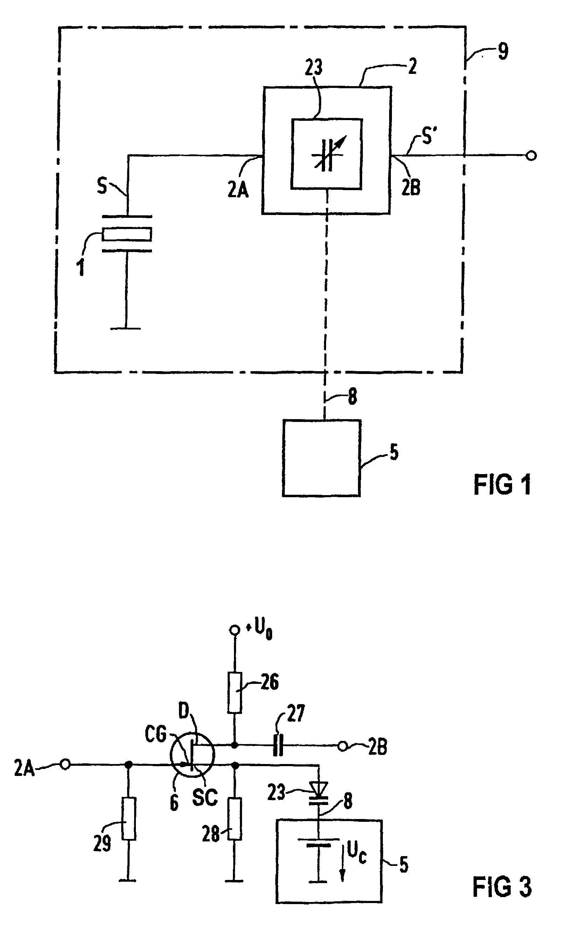

Der in FIG 1 gezeigte, mit 9 bezeichnete Ultraschallwandlerkopf enthält wenigstens ein Wandlerelement 1 und eine Verstärkereinrichtung 2 zum Verstärken der Empfangssignale S des Wandlerelements 1. An einen Eingang 2A der Verstärkereinrichtung 2 werden die Empfangssignale S des Wandlerelements 1 angelegt. Die verstärkten Empfangssignale können an einem Ausgang 2B der Verstärkereinrichtung 2 abgegriffen werden und sind mit S' bezeichnet.

Zum Steuern ihrer im allgemeinen komplexen Verstärkung $A^* = S'/S$ enthält die Verstärkereinrichtung 2 wenigstens ein steuerbares kapazitives Bauelement 23. Die Verstärkung $A^*$ der Verstärkereinrichtung 2 ist von der Kapazität C des steuerbaren kapazitiven Bauelements 23 abhängig. Zum Steuern der Kapazität C des kapazitiven Bauelements 23 und damit der Verstärkung $A^*$ der Verstärkereinrichtung 2 ist das wenigstens eine kapazitive Bauelement 23 über eine gestrichelt dargestellte Wirkverbindungslinie 8 mit Steuermitteln 5 verbunden. Die Wirkverbindung der Steuermittel 5 mit dem wenigstens einen zu steuernden kapazitiven Bauelement 23 kann beispielsweise über eine elektrische, optische, induktive oder auch piezoelektrische Kopplung erfolgen. Die Wirkverbindungslinie 8 kann dann entsprechend mit einer elektrischen Verbindung bzw. einem optischen Koppler bzw. einem induktiven Koppler bzw. einem Piezokoppler gebildet sein. Die Steuermittel 5 sind im allgemeinen außerhalb des Wandlerkopfs 9 angeordnet, können jedoch auch wenigstens teilweise im Wandlerkopf 9 integriert sein.

Als Wandlerelement 1 kann ein beliebiges piezoelektrisches Wandlerelement vorgesehen werden, insbesondere ein piezokeramisches Element. Das Wandlerelement 1 ist vorzugsweise Teil eines in FIG 1 nicht dargestellten Ultraschallarrays mit mehreren Wandlerelementen. Das Array kann ein lineares oder auch ein zweidimensionales, beispielsweise matrixförmiges Array sein. Solche Arrays sind im allgemeinen in einem Substrat durch Mikrostrukturierung integriert. Jedem Wandlerelement des Arrays ist dann eine steuerbare Verstärkereinrichtung zum Verstärken der Empfangssignale des Wandlerelements zugeordnet. Die Verstärkereinrichtungen sind zusammen mit den Wandlerelementen des Arrays im Wandlerkopf integriert.

Der Wandlerkopf 9 kann nur zum Empfangen von Ultraschall oder auch sowohl zum Senden als auch zum Empfangen von Ultraschall vorgesehen sein.

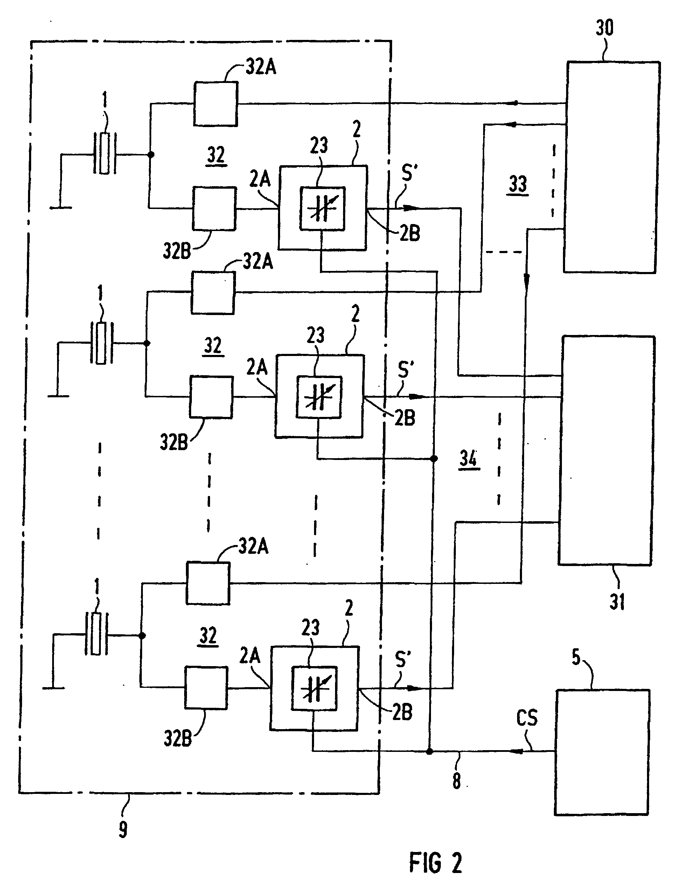

Das Ultraschallgerät zum Abbilden eines - nicht dargestellten - Objekts mit Ultraschall gemäß der FIG 2 enthält einen Wandlerkopf 9 sowohl zum Senden als auch zum Empfangen von Ultraschall mit einem Array von Wandlerelementen 1 und jeweils einer steuerbaren Verstärkereinrichtung 2 für jedes Wandlerelement 1. In einem Sendebetrieb des Ultraschallgeräts wird das Objekt mit Ultraschallpulsen der Wandlerelemente 1 beschallt. Ein Sender 30 sendet dazu über Sendeleitungen 33 Sendepulse zum Ansteuern jedes Wandlerelements 1, die derart beschaffen sind, daß die Wandlerelemente 1 zu Ultraschallschwingungen angeregt werden. Die Einschaltdauer eines einzelnen Sendepulses kann dabei im allgemeinen zwischen 50 ns und 500 ns und vorzugsweise um etwa 150 ns gewählt werden, und die Pulshöhe (Amplitude) der Sendepulse zwischen 50 und 150 V. Alle Wandlerelemente 1 des Arrays werden vorzugsweise phasenverzögert von dem Sender 30 angesteuert zum Erzeugen eines vorzugsweise fokussierbaren Ultraschallstrahls, der auf das Objekt gerichtet wird (elektronischer Scan). Bei einem Wandlerkopf mit nur einem einzelnen Wandlerelement 1 wird das Objekt dagegen mechanisch abgetastet durch Bewegen des Wandlerelements 1 (mechanischer Scan). In einem Empfangsbetrieb des Ultraschallgeräts werden die vom Objekt zu den Wandlerelementen 1 zurückreflektierten Ultraschallpulse in jedem Wandlerelement 1 in elektrische Empfangssignale S umgewandelt. Diese Empfangssignale S werden im Wandlerkopf 9 von der zugehörigen Verstärkereinrichtung 2 verstärkt, und die verstärkten Empfangssignale S' werden über Signalleitungen 34 signalverarbeitenden Mitteln 31 zum Aufbau eines Bildes des Objekts zugeführt. Die Impedanzen der Verstärkereinrichtungen 2 sind vorzugsweise wenigstens annähernd an die Impedanzen der zugeordneten Signalleitungen 34 angepaßt. Für jedes Wandlerelement 1 ist vorzugsweise ein Duplexer 32 vorgesehen zum Umschalten zwischen Sendebetrieb und Empfangsbetrieb. Ein erster Teil 32A des Duplexers 32 verbindet im Sendebetrieb das zugehörige Wandlerelement 1 mit dem Sender 30 und entkoppelt im Empfangsbetrieb den Sender 30 sowohl von der Verstärkereinrichtung 2 als auch von dem Wandlerelement 1. Ein zweiter Teil 32B des Duplexers 32 verbindet dagegen das Wandlerelement 1 im Empfangsbetrieb mit der Verstärkereinrichtung 2 und entkoppelt im Sendebetrieb die im allgemeinen empfindliche Verstärkereinrichtung 2' zum einen von dem Sender 30 zum Schutz vor dessen Sendepulsen und zum anderen von dem Wandlerelement 1. Das Wandlerelement 1 und die beiden Teile 32A und 32B des Duplexers 32 sind an einem gemeinsamen Schaltpunkt elektrisch verbunden. Wenigstens der zwischen Wandlerelement 1 und den Eingang 2A der zugeordneten Verstärkereinrichtung 2 angeordnete zweite Teil 32 B jedes Duplexers 32 ist mit dem Wandlerelement 1 und der Verstärkereinrichtung 2 im Wandlerkopf 9 integriert. Auch der erste Teil 32A kann wie dargestellt im Wandlerkopf 9 angeordnet sein. Für den Duplexer 32 können nicht dargestellte Steuerleitungen zum Umschalten zwischen Sende- und Empfangsbetrieb vorgesehen sein.

Jede Verstärkereinrichtung 2 enthält mindestens ein steuerbares kapazitves Bauelement 23. Jedes steuerbare kapazitve Bauelement 23 ist über vorzugsweise eine gemeinsame elektrische Steuerleitung 8 als Wirkverbindungslinie mit den Steuermitteln 5 verbunden. Die kapazitiven Bauelemente 23 werden von einem gemeinsamen Steuersignal CS angesteuert zum Steuern der Verstärkungen A* der Verstärkereinrichtungen 2. Diese Ausführungsform mit einer gemeinsamen Ansteuerung aller Verstärkereinrichtungen 2 ist besonders vorteilhaft bei im wesentlichen zueinander identisch aufgebauten und ausgelegten Wandlerelementen 1 und Verstärkereinrichtungen 2 im Wandlerkopf 9. Die Verstärkereinrichtungen 2 können aber auch jede für sich über eine oder mehrere Steuerleitungen bzw. Wirkverbindungslinien 8 mit den Steuermitteln 5 in Wirkverbindung stehen zum unabhängigen Steuern der Verstärkungen A* der Verstärkereinrichtungen 2. Außerdem kann die Wirkverbindung zwischen Verstärkereinrichtungen 2 und Steuermitteln 5 statt auf elektrischem Wege auch wieder auf einem der anderen beschriebenen Wege erfolgen.

Die Verstärkereinrichtung 2 enthält in einer vorteilhaften Ausführungsform wenigstens einen Verstärker, dessen Eingang mit dem Wandlerelement 1 verbunden ist und dessen Ausgang mit dem Ausgang 2B der Verstärkereinrichtung 2 verbunden ist. Zusätzlich ist eine Gegenkopplungsschaltung für den wenigstens einen Verstärker vorgesehen. Bei nur einem Verstärker wird der Ausgang des Verstärkers mit dessen Eingang verbunden. Ein Teil des Ausgangssignals des Verstärkers wird zum Eingang zurückgeführt und dem Eingangssignal des Verstärkers gegenphasig überlagert, so daß das wirksame Eingangssignal abgeschwächt wird. Bei mehreren hintereinandergeschalteten Verstärkern kann eine Gegenkopplungsschaltung für jeden einzelnen Verstärker vorgesehen sein oder eine Gegenkopplungsschaltung über wenigstens zwei und vorzugsweise alle aufeinanderfolgenden Verstärker oder eine Kombination aus solchen Einzel- und Mehrfach-Gegenkopplungen vorgesehen sein. Bei einer Gegenkopplung mehrerer hintereinandergeschalteter Verstärker wird das Ausgangssignal des letzten Verstärkers mit dem Eingangssignal des ersten Verstärkers gegengekoppelt. Die Gegenkopplungsschaltung des wenigstens einen Verstärkers enthält das wenigstens eine steuerbare kapazitive Bauelement 23. Eine Änderung der Kapazität C des wenigstens einen kapazitiven Bauelements 23 hat dann eine Änderung des Gegenkopplungsgrads und damit der Verstärkung A* der Verstärkereinrichtung 2 zur Folge.

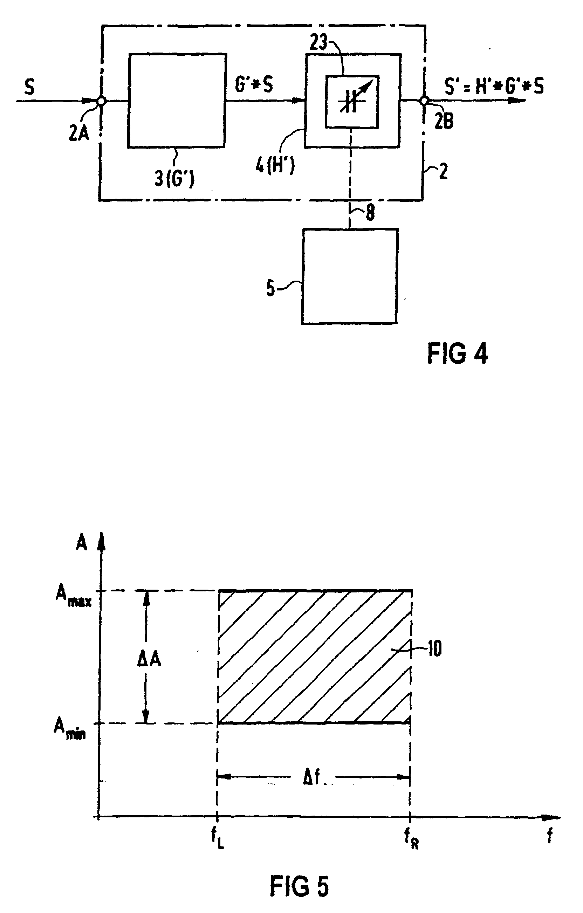

Ein erstes Ausführungsbeispiel für eine Verstärkereinrichtung 2 mit einem gegengekoppelten Verstärker ist in der FIG 3 dargestellt. Als Verstärker ist ein Feldeffekttransistor 6 vorgesehen mit einem Gate CG, einer Source SC und einer Drain D. Das Gate CG des Feldeffekttransistors 6 ist mit dem Eingang 2A der Verstärkereinrichtung 2 verbunden. Die Source SC des Feldeffekttransistors 6 ist mit einer Kapazitätsdiode als kapazitivem Bauelement 23 verbunden. Die Drain D bildet den Ausgang des Verstärkers und ist einerseits über eine Kapazität 27 mit dem Ausgang 2B der Verstärkereinrichtung 2 verbunden sowie andererseits über einen Widerstand 26 mit einer positiven Drainspannung $U_0$. Die Kapazitätsdiode 23 ist über eine Steuerleitung 8 mit einer Steuerspannungsquelle als Steuermitteln 5 verbunden, die die Kapazitätsdiode 23 in Sperrichtung mit einer Sperrspannung $U_C$ vorspannt. Durch die Kapazitätsdiode 23 wird das Ausgangssignal des Feldeffekttransistors 6 teilweise auf dessen Eingangssignal gegengekoppelt. Ändert man deshalb durch Steuern der Sperrspannung $U_C$ die Kapazität C der Kapazitätsdiode 23, so verändert sich der Gegenkopplungsgrad des Verstärkers 6 und damit die Verstärkung A* der Verstärkereinrichtung 2. Allerdings ist die Gegenkopplung mit dem kapazitiven Bauelement 23 und die Verstärkung der Verstärkereinrichtung 2 wegen des Einflusses der Kapazität C des kapazitiven Bauelements 23 frequenzabhängig, im dargestellten Fall in Form eines Hochpaßverhaltens. Diese Frequenzabhängigkeit kann aber bei der Signalauswertung der verstärkten Empfangssignale S' berücksichtigt und korrigiert werden. Ferner sind vorzugsweise noch ein Widerstand 29 zum Festlegen des Gatepotentials am Gate CG des Feldeffekttransistors 6 und ein Widerstand 28 vorgesehen, der bewirkt, daß an der Source SC ebenfalls das Ausgangssignal auftritt, das zur Gegenkopplung verwendet wird.

In einer besonders vorteilhaften Ausführungsform der Verstärkereinrichtung 2 wird die Verstärkung A* der Verstärkereinrichtung 2 zwar durch Steuern der Kapazität C wenigstens eines kapazitiven Bauelements 23, jedoch im wesentlichen frequenzunabhängig gesteuert. Diese Ausführungsform wird anhand der FIG 4 bis 16 näher beschrieben.

In FIG 4 ist der prinzipielle Aufbau einer solchen Verstärkereinrichtung 2 mit frequenzunabhängiger Verstärkungssteuerung gezeigt. Die Verstärkereinrichtung 2 umfaßt ein erstes Übertragungsglied 3 mit einer im allgemeinen komplexen Übertragungsfunktion G', ein zweites Übertragungsglied 4 mit einer im allgemeinen komplexen Übertragungsfunktion H'. Das erste Übertragungsglied 3 und das zweite Übertragungsglied 4 sind zwischen den Eingang 2A und den Ausgang 2B der Verstärkereinrichtung 2 elektrisch in Reihe geschaltet. Das zu verstärkende elektrische Empfangssignal S des Wandlerelements 1 wird an den Eingang 2A der Verstärkereinrichtung 2 angelegt und dem ersten Übertragungsglied 3 zugeführt. In dem ersten Übertragungsglied 3 wird das Empfangssignal S mit der Übertragungsfunktion G' des ersten Übertragungsgliedes 3 multipliziert. Das erhaltene, mit der Übertragungsfunktion G' verstärkte oder multiplizierte Empfangssignal G' * S wird nun dem zweiten Übertragungsglied 4 zugeführt und von diesem mit dessen Übertragungsfunktion H' verstärkt. Das mit beiden Übertragungsfunktionen G' und H' beider Übertragungsglieder 3 und 4 multiplizierte Empfangssignal S' = H' * G' * S ist an dem Ausgang 2B der Verstärkereinrichtung 2 als verstärktes Empfangssignal abgreifbar.

Es gilt somit die Beziehung

$$S'/S = H' * G' \qquad (1)$$

zwischen der im allgemeinen komplexen Amplitude des verstärkten Empfangssignals S' am Ausgang 2B der Verstärkereinrichtung 2 und der im allgemeinen komplexen Amplitude des unverstärkten Empfangssignals S am Eingang 2A der Verstärkereinrichtung 2 mit dem Produkt H' * G' der beiden komplexen Übertragungsfunktionen G' und H' als komplexer elektrischer Verstärkung oder komplexer Übertragungsfunktion A* der gesamten Verstärkereinrichtung 2.

Wendet man auf die komplexen Größen auf beiden Seiten der Gleichung (1) zunächst die Betragsfunktion $||$ und dann die Logarithmusfunktion $\log_a$ zu einer vorgegebenen reellen Basis a an, so erhält man die reelle logarithmische Verstärkung

$$A := \log_a (|S'|/|S|) = G + H \qquad (2)$$

der Verstärkereinrichtung 2 mit den reellen logarithmischen Übertragungsfunktionen

$$G := \log_a(|G'|)$$

$$H := \log_a(|H'|)$$

Die logarithmische Verstärkung A der Verstärkereinrichtung 2 entspricht somit der Summe aus den logarithmischen Übertragungsfunktionen $G = \log_a(|G'|)$ und $H = \log_a(|H'|)$ der beiden Übertragungsglieder 3 und 4 der Verstärkereinrichtung 2.

Wenigstens eines der beiden Übertragungsglieder 3 oder 4 enthält wenigstens ein steuerbares kapazitives Bauelement 23. Die Steuermittel 5 stehen mit jedem dieser steuerbaren kapazitiven Bauelemente 23 in der Verstärkereinrichtung 2 in Wirkverbindung. Im Beispiel der FIG 4 sind die Steuermittel 5 nur mit einem kapazitiven Bauelement im Übertragungsglied 4 über die gestrichelt gezeichnete Wirkverbindungslinie 8 verbunden. Die Steuermittel 5 steuern jedes mit ihnen verbundene kapazitive Bauelement 23 im Übertragungsglied 3 oder 4 derart, daß die Übertragungsfunktion G' bzw. H' dieses Übertragungsglieds 3 bzw. 4 in ihrer Frequenzabhängigkeit geändert wird. Die genaue Funktionsweise dieser Steuerung wird im folgenden erläutert.

In FIG 5 ist anhand eines Diagramms veranschaulicht, wie die logarithmische Verstärkung $A = \log_a(|S'|/|S|)$ der Verstärkereinrichtung 2 vorzugsweise gesteuert werden soll. In einem mit $\Delta f$ bezeichneten vorgegebenen Ultraschallfrequenzband zwischen einer linken Eckfrequenz $f_L$ und einer rechten Eckfrequenz $f_R$ soll die logarithmische Verstärkung A zwischen einer minimalen Verstärkung $A_{min}$ und einer maximalen Verstärkung $A_{max}$ um eine Verstärkungsvariation $\Delta A = A_{max} - A_{min} > 0$ variiert werden können und dabei zumindest innerhalb des vorgegebenen Frequenzbereichs $\Delta f$ im

wesentlichen frequenzunabhängig sein. Der entsprechende, durch die Intervalle Δf und ΔA vorgegebene rechteckige Verstärkungssteuerungsbereich ist schraffiert und mit 10 bezeichnet. Die minimale logarithmische Verstärkung $A_{min}$ wird im allgemeinen größer oder gleich 0 gewählt, kann aber auch kleiner als 0 sein. Auch die maximale Verstärkung $A_{max}$ kann kleiner als 0 sein. Die Amplitude des Ausgangssignals S' der Verstärkereinrichtung 2 ist in diesen Fällen betragsmäßig kleiner als die Amplitude des Eingangssignals S.

Um eine Verstärkungsvariation ΔA gemäß FIG 5 innerhalb des vorgegebenen Frequenzbandes Δf zu erreichen, werden die logarithmischen Übertragungsfunktionen $G = \log_a(|G'|)$ und $H = \log_a(|H'|)$ der beiden Übertragungsglieder 3 bzw. 4 nun so eingestellt, daß sie jeweils wenigstens in einem jeweils vorgegebenen Frequenzbereich wenigstens annähernd lineare Funktionen

$$G = - m \cdot (\nu(f) - \nu_G) \qquad (3a)$$

$$H = + m \cdot (\nu(f) - \nu_H) \qquad (3b)$$

einer bijektiven Funktion $\nu = \nu(f)$ der Frequenz f der Empfangssignale S sind. Die bijektive oder eindeutige Funktion $\nu(f)$ der Frequenz f bestimmt den Maßstab, in dem die Frequenz f dargestellt wird, und ist vorzugsweise gleich $\log_a(f)$, insbesondere $\log(f) := \log_{10}(f)$, oder gleich der identischen Funktion $I(f) = f$. Der erste reelle Übertragungsparameter $m \neq 0$ gibt den Betrag der Steigungen $|dG/d\nu|$ und $|dH/d\nu|$ der beiden logarithmischen Übertragungsfunktionen G und H in ihren linear gemäß den Gleichungen (3a) bzw. (3b) verlaufenden Bereichen an. Die weiteren reellen Übertragungsparametern $\nu_G$ und $\nu_H$ der logarithmischen Übertragungsfunktion G bzw. H entsprechen dem Funktionswert $\nu(f_G)$ bzw. $\nu(f_H)$ der Funktion $\nu(f)$ an einer Stelle $f = f_G$ bzw. $f = f_H$. Die logarithmische Übertragungsfunktion G des Übertragungsglieds 3 weist somit in dem zugehörigen Frequenzbereich eine lineare Flanke mit der Steigung -m auf, während die logarithmische Übertragungsfunktion H des zweiten Übertragungsglieds 4 in ihrem zugeordneten Frequenzbereich eine lineare Flanke mit der Steigung +m aufweist. Die Steigungen der beiden Flanken sind unterschiedlich in ihren Vorzeichen, aber gleich in ihrem Betrag.

Die beiden logarithmischen Übertragungsfunktionen G und H der Übertragungsglieder 3 bzw. 4 werden nun so eingestellt, daß beide logarithmischen Übertragungsfunktionen G und H über dem in FIG 5 dargestellten, vorgegebenen Frequenzband $Δf = [f_L,f_R]$ bzw. dem entsprechenden Intervall $Δf = [\nu(f_L),\nu(f_R)]$ einen linearen Verlauf gemäß den Gleichungen (3a) und (3b) aufweisen. Man erhält dann durch Einsetzen der Beziehungen (3a) und (3b) in die Gleichung (2) für die logarithmische Verstärkung A der Verstärkereinrichtung 2 wenigstens annähernd den Ausdruck

$$A = m \cdot (\nu_G - \nu_H) \qquad (4).$$

Wenigstens für Frequenzen f aus dem Frequenzbereich Δf bzw. für Funktionswerte $\nu(f)$ aus dem entsprechenden, eindeutig bestimmten Wertebereich $Δ\nu$ ist die logarithmische Verstärkung A - und damit natürlich auch die komplexe Verstärkung A* - der Verstärkereinrichtung 2 somit zumindest annähernd frequenzunabhängig.

Dieser praktisch frequenzunabhängige Wert der logarithmischen Verstärkung A gemäß Gleichung (4) kann nun durch geeignete Einstellung von wenigstens einem der Übertragungsparameter m, $\nu_G$ und $\nu_H$ der beiden logarithmischen Übertragungsfunktionen G und H in einer für eine bestimmte Anwendung der Verstärkereinrichtung 2 geeigneten Weise verändert werden. Die so erreichbare Verstärkungsvariation ΔA der Verstärkereinrichtung 2 ist abhängig von der Variation Δm des Betrags m der Steigungen beider logarithmischer Übertragungsfunktionen G und H im Bereich ihrer Flanken und/oder der Variation $Δ\nu_G$ des Übertragungsparameters $\nu_G$ der Flanke der logarithmischen Übertragungsfunktion G und/oder der Variation $Δ\nu_H$ des Übertragungsparameters $\nu_H$ der Flanke der logarithmischen Übertragungsfunktion H. Die Variationen $Δ\nu_G$ und $Δ\nu_H$ entsprechen einer Verschiebung der Flanke der zugehörigen logarithmischen Übertragungsfunktion G bzw. H. Die Variation Δm entspricht einem Verändern der absoluten Steilheiten beider Flanken.

Der genaue Verlauf der logarithmischen Übertragungsfunktionen G und H der beiden Übertragungsglieder 3 und 4 außerhalb des vorgegebenen Frequenzbandes $Δf = [f_L,f_R]$ bzw. des entsprechenden Intervalls $Δ\nu = [\nu(f_L),\nu(f_R)]$ ist für die Steuerung der Verstärkung A nicht wichtig.

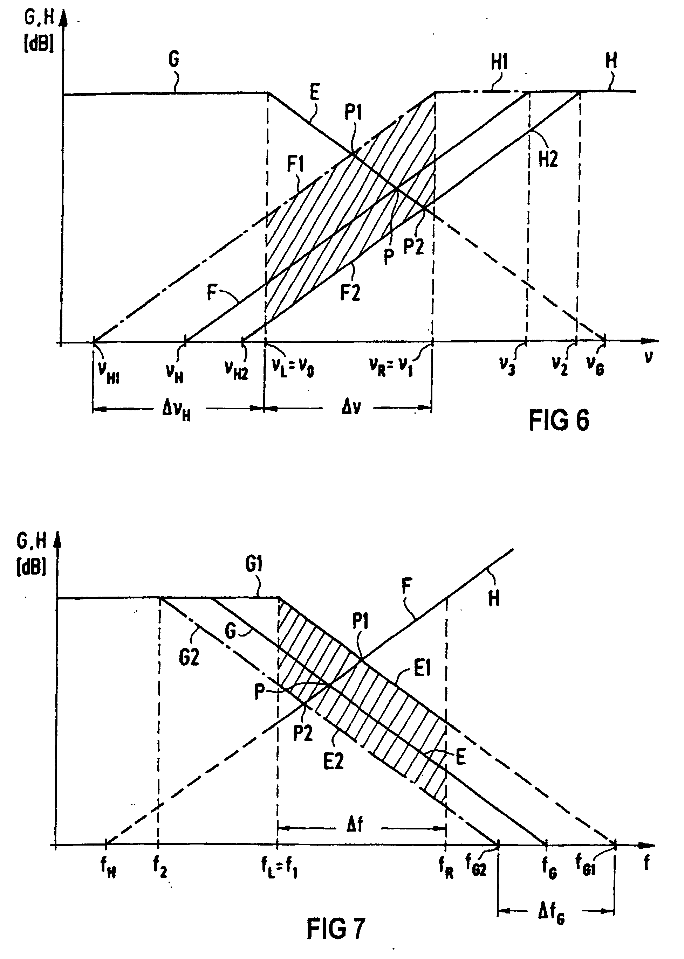

In den FIG 6 bis 8 sind anhand von Diagrammen Ausführungsbeispiele gezeigt, wie durch Variation der logarithmischen Übertragungsfunktionen G und H der beiden Übertragungsglieder 3 und 4 die logarithmische Verstärkung A der Verstärkereinrichtung 2 gesteuert werden kann. Dabei wird im folgenden ohne Beschränkung der Allgemeinheit die in der Elektronik übliche dezimale logarithmische Verstärkung oder Übertragungsfunktion

$$A/dB = 20 \log (|S'|/|S|)$$

$$G/dB = 20 \log (|G'|)$$

$$H/dB = 20 \log (|H'|)$$

mit dem Logarithmus log := $\log_{10}$ zur Basis 10 verwendet.

Die FIG 6 und 7 zeigen Ausführungsbeispiele, bei denen die Flanke einer der beiden logarithmischen Übertragungsfunktionen variiert wird und die Flanke der anderen logarithmischen Übertragungsfunktion festgehalten wird. In der Ausführungsform gemäß FIG 8 werden dagegen die Flanken beider logarithmischen Übertragungsfunktionen variiert.

Im Diagramm der FIG 6 sind zwei logarithmische Übertragungsfunktionen G und H über der Funktion $\nu = \nu(f)$ aufgetragen. Die logarithmische Übertragungsfunktion G des ersten Übertragungsglieds 3 ist für Werte $\nu \leq \nu_0$ links von einem Funktionsgrenzwert $\nu_0$ praktisch konstant und fällt für $\nu > \nu_0$ rechts von diesem Funktionsgrenzwert $\nu_0$ entlang einer Flanke E im wesentlichen linear gemäß der Beziehung (3a) mit einem positiven Übertragungsparameter $m > 0$ ab. Eine solche Übertragungsfunktion G ist charakteristisch für einen Tiefpaß (bzw. Tiefpaßverstärker) als Übertragungsglied 3. Der Funktionsgrenzwert $\nu_0$ entspricht dabei dem Wert der Funktion $\nu(f)$ bei der Grenzfrequenz des Tiefpasses. Der Übertragungsparameter $\nu_G$ entspricht dem Wert von $\nu$, bei dem die verlängerte Flanke E die Abszisse schneidet. Bei $\nu = \nu_G$ nimmt die logarithmische Übertragungsfunktion G einen vorbestimmten Wert, beispielsweise den Wert 0 dB, an. Die Flanke E der logarithmischen Übertragungsfunktion G wird während des Betriebs der Verstärkereinrichtung 2 konstantgehalten. Die logarithmische Übertragungsfunktion H des zweiten Übertragungsglieds 4 weist eine mit steigendem $\nu$ gemäß der Beziehung (3b) mit der Steigung $+m > 0$ linear ansteigende Flanke F auf, die ab einem bestimmten Funktionsgrenzwert $\nu_3$ in einen im wesentlichen konstant verlaufenden Teil der logarithmischen Übertragungsfunktion H übergeht. Diese logarithmische Übertragungsfunktion H entspricht der charakteristischen Kennlinie eines Hochpasses als Übertragungsglied 4.

Die Flanke F der logarithmische Übertragungsfunktion H ist nun zwischen zwei mit F1 und F2 bezeichneten Flanken von zwei entsprechenden logarithmische Übertragungsfunktionen H1 und H2 mit gleicher Steigung $+m$ verschiebbar. Beim Verschieben wird der Übertragungsparameter $\nu_H$ der logarithmischen Übertragungsfunktion H in dem von den beiden Übertragungsparametern $\nu_{H1}$ und $\nu_{H2}$ der beiden logarithmischen Übertragungsfunktionen H1 und H2 mit $\nu_{H1} < \nu_{H2}$ begrenzten Intervall variiert. Die Übertragungsparameter $\nu_H$, $\nu_{H1}$ und $\nu_{H2}$ entsprechen den Werten von $\nu$, bei denen die verlängerte Flanke F, F1 bzw. F2 die Abszisse schneidet. Bei $\nu = \nu_H$, $\nu = \nu_{H1}$ oder $\nu = \nu_{H2}$ nimmt die zugehörige logarithmische Übertragungsfunktion H, H1 bzw. H2 einen vorbestimmten Wert, beispielsweise wieder 0 dB, an. Die durch den Übertragungsparameter $+m$ definierte Steigung der logarithmischen Übertragungsfunktion H bleibt beim Verschieben der Flanke F unverändert. Die gewählte Variation $\Delta\nu_H = \nu_{H2} - \nu_{H1}$ des Übertragungsparameters $\nu_H$

entspricht in dieser Ausführungsform einer Variation des Funktionsgrenzwertes $\nu_3$ zwischen dem Funktionsgrenzwert $\nu_1$ der ersten logarithmischen Übertragungsfunktion H1 und dem Funktionsgrenzwert $\nu_2$ der zweiten logarithmischen Übertragungsfunktion H2, die wiederum einer Variation der Grenzfrequenz des Hochpasses entspricht. Über einem zwischen dem Funktionsgrenzwert $\nu_0$ der logarithmischen Übertragungsfunktion G des Tiefpasses als linkem Funktionswert $\nu_L$ und dem kleinsten Funktionsgrenzwert $\nu_1$ der logarithmischen Übertragungsfunktion H des Hochpasses als rechtem Funktionswert $\nu_R$ liegenden Funktionswertebereich $\Delta\nu$ ist also die Flanke F der logarithmischen Übertragungsfunktion H in dem schraffierten Bereich relativ zur Flanke E der logarithmischen Übertragungsfunktion G verschiebbar.

Der Schnittpunkt P zwischen den beiden Flanken E und F liegt auf der Flanke E zwischen den beiden extremen Schnittpunkten P1 der Flanke F1 mit der Flanke E und P2 der Flanke F2 mit der Flanke E. Die logarithmische Verstärkung A der Verstärkereinrichtung 2 kann graphisch als doppelter Wert einer der beiden logarithmischen Übertragungsfunktionen G oder H bei diesem Schnittpunkt P ermittelt werden. Der maximale Wert $A_{max}$ der logarithmischen Verstärkung A entspricht dem Schnittpunkt P1, der minimale Wert $A_{min}$ dagegen dem Schnittpunkt P2.

Mit der Variation $\Delta\nu_H = \nu_{H2} - \nu_{H1}$ der Flanke F der logarithmische Übertragungsfunktion H zwischen den Flanken F1 und F2 ist also eine Variation $\Delta A = A_{max} - A_{min}$ der logarithmischen Verstärkung A der Verstärkereinrichtung 2 zwischen den beiden Extremwerten $A_{max}$ und $A_{min}$ in dem Funktionswertebereich $\Delta\nu$ und damit in dem entsprechenden Frequenzbereich $\Delta f$ für das elektrische Signal S erreichbar. Die Verstärkungsvariation $\Delta A$ errechnet sich gemäß der Beziehung (4) zu

$$\Delta A = |\,m\,| \cdot \Delta\nu_H \qquad (5),$$

ist also proportional zur Variation $\Delta\nu_H$ des Übertragungsparameters $\nu_H$ der logarithmischen Übertragungsfunktion H des zweiten Übertragungsglieds 4 mit dem Betrag des Übertragungsparameters $m$ als Proportionalitätskonstanten.

Im Diagramm gemäß FIG 7 sind die beiden logarithmischen Übertragungsfunktionen G und H über der Frequenz f aufgetragen, d.h. es ist $\nu(f) = f$ gewählt. In dem dargestellten Ausführungsbeispiel wird nun die logarithmische Übertragungsfünktion H mit der Flanke F mit positiver Steigung (positive Flanke) konstantgehalten, während die logarithmische Übertragungsfunktion G mit der Flanke E mit negativer Steigung (negative Flanke) variiert wird. Der Übertragungsparameter $f_H$ der logarithmischen Übertragungsfunktion H bleibt also konstant. Der Übertragungsparameter $f_G$ der logarithmischen Übertragungsfunktion G wird hingegen zwischen den beiden Übertragungsparametern $f_{G2}$ und $f_{G1}$ von zwei logarithmischen Übertragungsfunktionen G2 bzw. G1 mit $f_{G2} < f_{G1}$ gesteuert. Die entsprechende Variation von $f_G$ ist mit $\Delta f_G = f_{G1} - f_{G2}$ bezeichnet. Die Flanke E der logarithmischen Übertragungsfunktion G ist somit bei unveränderter Steigung m zwischen den beiden Flanken E2 und E1 der beiden logarithmischen Übertragungsfunktionen G2 bzw. G1 in einem Frequenzbereich $\Delta f$ zwischen einer linken Eckfrequenz $f_L$ und einer rechten Eckfrequenz $f_R$ verschiebbar mit $f_L < f_R$. Der Variationsbereich der Flanke E über dem Frequenzbereich $\Delta f$ ist wieder schraffiert.

Der Schnittpunkt P der beiden Flanken E und F variiert zwischen dem Schnittpunkt P2 der Flanke E2 mit der Flanke F und dem Schnittpunkt P1 der Flanke E1 mit der Flanke F. Die resultierende logarithmische Verstärkung A der Verstärkereinrichtung 2 entspricht wieder dem doppelten Wert der logarithmische Übertragungsfunktion G oder H bei dem Schnittpunkt P.

Die Variation $\Delta A$ der logarithmischen Verstärkung A zwischen deren maximalen Wert $A_{max}$ und derem minimalen Wert $A_{min}$ ist gemäß Gleichung (4) im wesentlichen gleich

$$\Delta_A = |\,m\,| \cdot \Delta f_G \qquad (6),$$

ist also proportional zur Variation $\Delta f_G$ des Übertragungsparameters $f_G$ der logarithmischen Übertragungsfunktion G des ersten Übertragungsglieds 3 mit dem Betrag des Übertragungsparameters m als Proportionalitätskonstanten.

Die logarithmische Übertragungsfunktion G kann wieder mit einem Übertragungsglied 3 mit Tiefpaßcharakter realisiert werden. In dem dargestellten Ausführungsbeispiel entspricht eine Variation $\Delta f_G$ des Übertragungsparameters $f_G$ von $f_{G2}$ nach $f_{G1}$ dann auch einer Variation der Grenzfrequenz des Tiefpasses von $f_2$ bis $f_1$. Die dargestellte logarithmische Übertragungsfunktion H weist eine durchgehende Flanke F auf und kann beispielsweise mit einem Differenzierglied (Differentiator) im Übertragungsglied 4 verwirklicht werden.

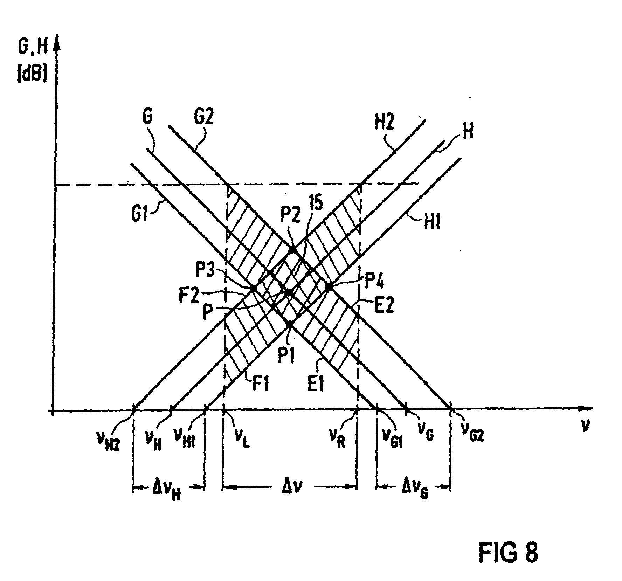

Im Ausführungsbeispiel der FIG 8 sind nun die Flanken E und F beider logarithmischen Übertragungsfunktionen G und H innerhalb des vorgegebenen Funktionswerteintervalls $\Delta v$ verschiebbar. Der Übertragungsparameter $v_G$ der logarithmischen Übertragungsfunktion G des ersten Übertragungsglieds 3 wird in dem von den beiden Übertragungsparametern $v_{G1}$ und $v_{G2}$ der beiden logarithmische Übertragungsfunktionen G1 und G2 mit $v_{G1} < v_{G2}$ begrenzten Variationsintervall gesteuert. Die der Länge des Variationsintervalls entsprechende, maximale Variation des Übertragungsparameters $v_G$ ist mit $\Delta v_G = v_{G2} - v_{G1}$ bezeichnet. Der Übertragungsparameter $v_H$ der logarithmischen Übertragungsfunktion H des zweiten Übertragungsglieds 4 wird dagegen in dem von den beiden Übertragungsparametern $v_{H1}$ und $v_{H2}$ der beiden logarithmische Übertragungsfunktionen H1 und H2 mit $v_{H1} > v_{H2}$ begrenzten Variationsintervall mit der maximalen Variation $\Delta v_H = v_{H1} - v_{H2}$ variiert. Die entsprechende Variationsbereiche der Flanken E und F über dem Intervall $\Delta v$ sind jeweils einfach schraffiert.

Der Schnittpunkt P der beiden Flanken E und F liegt in dem doppelt schraffierten, parallelogrammförmigen Bereich 15 mit den vier Eckpunkten P1, P2, P3 und P4. Der Eckpunkt P1 ist der Schnittpunkt der beiden Flanken E1 und F1, der Eckpunkt P2 ist der Schnittpunkt der Flanken E2 und F2, der Eckpunkt P3 ist der Schnittpunkt der Flanken E1 und F2 und der Eckpunkt P4 ist der Schnittpunkt der Flanken E2 und F1. Die Verstärkung A der Verstärkereinrichtung 2 ist maximal, d.h. A = $A_{max}$, wenn der Schnittpunkt P = P2 ist und minimal, d.h. A = $A_{min}$, wenn der Schnittpunkt P = P1 ist.

Die Variation $\Delta A$ der Verstärkung A ist nun zumindest annähernd gleich

$$\Delta_A = |\,m\,| \cdot (\Delta v_G + \Delta v_H) \qquad (7).$$

Verglichen mit der Variation $\Delta v_G$ oder $\Delta v_H$ der Flanke E bzw. F nur einer Übertragungsfunktion G bzw. H ist die Variation $\Delta A$ der Verstärkung A bei Variation beider Übertragungsparameter $v_G$ und $v_H$ also gleich der Summe der Einzelvariationen $\Delta A$ gemäß den Gleichungen (7) oder (6). Im Falle gleicher Variationen $\Delta v_G$ = $\Delta v_H$ ist die Verstärkungsvariation $\Delta A$ bei Verschieben beider Flanken E und F durch Verändern ihres zugehörigen Übertragungsparameters $v_G$ bzw. $v_H$ doppelt so groß wie bei Variation nur eines Übertragungsparameters $v_G$ oder $v_H$, d.h. bei Verschieben nur einer Flanke E oder F.

Bei allen Ausführungsformen der beiden Übertragungsglieder 3 und 4 der Verstärkereinrichtung 2 kommt es nur darauf an, daß die logarithmischen Übertragungsfunktionen G und H der beiden Übertragungsglieder 3 und 4 in Abhängigkeit von der Frequenz f des Eingangssignals S oder der bijektiven Funktion $v(f)$ dieser Frequenz f jeweils wenigstens eine lineare Flanke E und F aufweisen mit entgegengesetzten Steigungen und daß diese beiden Flanken E und F relativ zueinander in dem vorgegebenen Frequenzbereich $\Delta f$ (bzw. $\Delta v$ (f)) verschiebbar sind. Außerhalb dieses Frequenzbereichs $\Delta f$ (bzw. $\Delta v(f)$) kann der Frequenzgang der Übertragungsglieder 3 und 4 im Prinzip beliebig sein. Die Reihenfolge des Übertragungsgliedes mit der positiven Flanke und des Übertragungsgliedes mit der negativen Flanke in der Schaltungsanordnung zwischen dem Eingang 2A und dem Ausgang 2B der Verstärkereinrichtung 2 ist außerdem austauschbar.

Ein Übertragungsglied mit einer positiven Flanke wie beispielsweise der Flanke F in den FIG 6 bis 8 kann vorzugsweise mit Hilfe eines Hochpasses n-ter Ordnung mit n ≥ 1, eines Differenziergliedes oder eines Preemphasisgliedes gebildet werden. Ein Übertragungsglied mit einer negativen Flanke wie beipielsweise die Flanke E in den FIG 6 bis 8 enthält vorzugsweise einen Tiefpaß n-ter Ordnung mit n ≥ 1, ein Integrierglied (Integrator) oder ein Deemphasisglied. Jedes Übertragungsglied umfaßt vorzugsweise jeweils wenigstens einen Verstärker zum Einstellen der absoluten Größe der zugehörigen Übertragungsfunktion.

Ferner kann in einer nicht dargestellten Ausführungsform die Verstärkereinrichtung 2 auch wenigstens einen Verstärker mit einer zumindest im Frequenzbereich Δf frequenzunabhängigen Verstärkung enthalten, der elektrisch in Reihe zu den beiden Übertragungsgliedern 3 und 4 geschaltet wird.

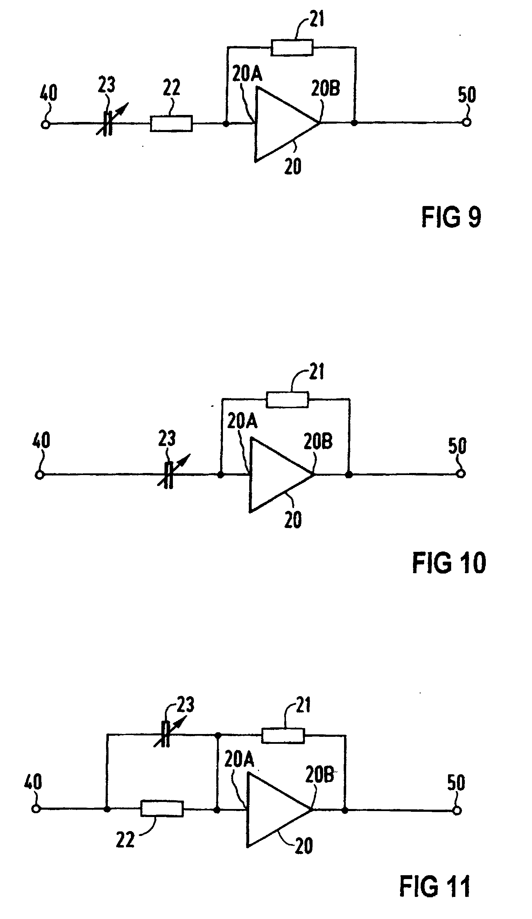

Die genannten Beispiele für die Übertragungsglieder 3 und 4 der Verstärkereinrichtung 2 sind dem Fachmann in einer Vielzahl von Ausführungsformen bekannt. Die FIG 9 bis 14 zeigen einfache Grundschaltungen für derartige Übertragungsglieder. Alle dargestellten Übertragungsglieder enthalten einen gegengekoppelten Verstärker 20 mit einem Eingang 20A und mit einem Ausgang 20B sowie ein kapazitives Bauelement 23. Der Eingang des Übertragungsglieds entspricht dem Punkt 40, und der Ausgang des Übertragungsglieds entspricht dem Punkt 50. Der Schaltungspunkt 50 ist mit dem Ausgang 20B des Verstärkers 20 elektrisch verbunden.

In FIG 9 ist eine Grundschaltung eines Hochpasses erster Ordnung (n = 1) dargestellt. Der Eingang 20A des Verstärkers 20 ist mit dem Ausgang 20B des Verstärkers 20 über einen ersten elektrischen Widerstand 21 rückgekoppelt. Ein Minuszeichen am Eingang 20A des Verstärkers 20 soll andeuten, daß der rückgekoppelte Teil des Ausgangssignal das Eingangssignal reduziert, also eine Gegenkopplung vorliegt. Ein Eingangssignal am Eingang 40 des Hochpasses wird über eine Reihenschaltung eines zweiten elektrischen Widerstands 22 und des steuerbaren kapazitiven Bauelements 23 auf den Eingang 20A des Verstärkers 20 geschaltet. Die Grenzfrequenz des Hochpasses ist nun proportional zu 1/(RC) mit der Größe R des zweiten elektrischen Widerstands 22 und der Kapazität C des kapazitiven Bauelements 23. Ein Hochpaß n-ter Ordnung mit n > 1 kann einfach durch Hintereinanderschalten von n Hochpässen erster Ordnung aufgebaut werden. Die Steigung der ansteigenden positiven Flanke des Hochpasses n-ter Ordnung entspricht der n-fachen Steigung der positiven Flanke des Hochpasses erster Ordnung. Durch Verwenden eines Hochpasses höherer Ordnung für ein Übertragungsglied läßt sich also die Verstärkungsvariation ΔA der Verstärkereinrichtung 2 entsprechend vervielfachen.

FIG 10 zeigt eine Ausführungsform eines Differenzierglieds (Differentiators). Der Ausgang 20B des Verstärkers 20 ist mit dem Eingang 20A über den Widerstand 21 elektrisch verbunden. zwischen diesen gegengekoppelten Eingang 20 A des Verstärkers und den Eingang 40 des Differenzierglieds ist das kapazitive Bauelement 23 geschaltet. Dieses Differenzierglied erhält man aus der Grundschaltung für den Hochpaß gemäß FIG 9 durch Weglassen des zweiten Widerstands 22. Das Differenzierglied weist keine Grenzfrequenz auf.

Beim Preemphasisglied gemäß FIG 11 ist der Ausgang 20B des Verstärkers 20 wieder über den ersten Widerstand 21 mit dem Eingang 20A des Verstärkers 20 gegengekoppelt. Der Eingang 40 des Preemphasisglieds ist nun über eine Parallelschaltung des zweiten Widerstands 22 und des kapazitiven Bauelements 23 mit dem Eingang 20A des Verstärkers 20 elektrisch verbunden. Die Grenzfrequenz des Preemphasisglieds ist proportional zu 1/(RC), wobei R der ohmsche Widerstand des zweiten Widerstands 22 und C die elektrische Kapazität des kapazitiven Bauelements 23 sind.

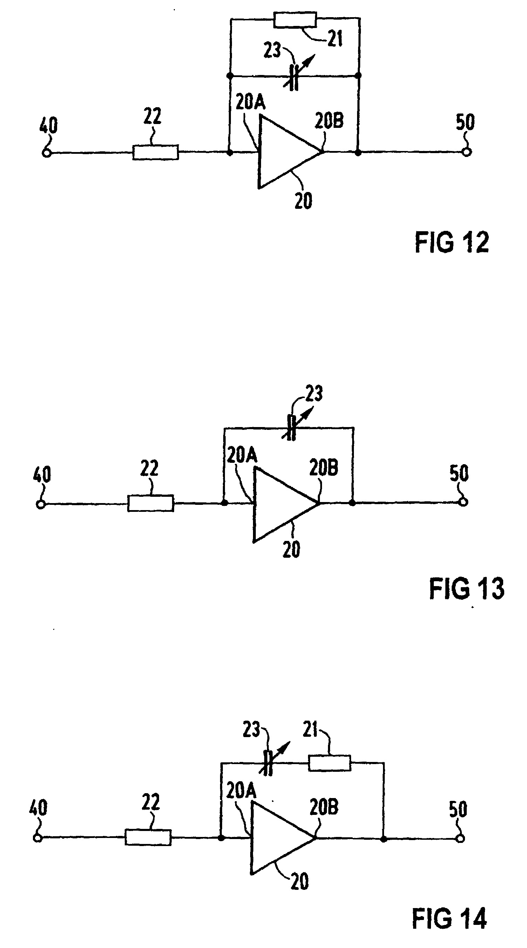

In FIG 12 ist eine Ausführungsform eines Tiefpasses erster Ordnung dargestellt. Der Ausgang 20B des Verstärkers 20 ist über eine Parallelschaltung des ersten Widerstands 21 und des kapazitiven Bauelements 23 mit dem Eingang 20A des Verstärkers 20 elektrisch verbunden. Der Eingang 40 des Tiefpasses ist über den zweiten Widerstand 22 mit dem Eingang 20A des Verstärkers 20 elektrisch verbunden. Die Grenzfrequenz des Tiefpasses ist proportional zu 1/(RC) mit der Größe R des ersten elektrischen Widerstands 21 und der Kapazität C des kapazitiven Bauelements 23. Ein Tiefpaß n-ter Ordnung mit n > 1 kann einfach durch Hintereinanderschalten von n Tiefpässen erster Ordnung aufgebaut werden. Die Steigung der abfallenden negativen Flanke des Tiefpasses n-ter Ordnung entspricht der n-fachen Steigung der negativen Flanke des Tiefpasses erster Ordnung. Durch Verwenden eines Tiefpasses höherer Ordnung für ein Übertragungsglied läßt sich also die Verstärkungsvariation ΔA der Verstärkereinrichtung 2 entsprechend vervielfachen.

In der FIG 13 ist eine Ausführungsform eines Integrierglieds (Integrators) veranschaulicht. Ausgang 20B und Eingang 20A des Verstärkers 20 sind über das kapazitive Bauelement 23 elektrisch gegengekoppelt. Vor den Eingang 20A des Verstärkers 20 ist der Widerstand 22 geschaltet. Das Integrierglied gemäß FIG 13 kann durch Weglassen des Widerstands 21 im Übertragungsglied gemäß FIG 12 erhalten werden. Eine Grenzfrequenz besitzt das Integrierglied nicht.

Die FIG 14 schließlich zeigt eine Grundschaltung eines Deemphasisglieds als Übertragungsglied. Zwischen Ausgang 20B und Eingang 20A des Verstärkers 20 ist eine Serienschaltung des ersten Widerstands 21 und des kapazitiven Bauelements 23 geschaltet. Der Eingang 20A des Verstärkers 20 ist ferner über den zweiten Widerstand 22 mit dem Eingang 40 des Deemphasisglieds elektrisch verbunden. Die Grenzfrequenz des Deemphasisglieds ist proportional zu 1/(RC) mit dem ohmschen Widerstand R des ersten Widerstands 21 und der Kapazität C des kapazitiven Bauelements 23.

Zum Verschieben der Flanken E und F der Übertragungsfunktionen G bzw. H der Übertragungsglieder 3 bzw. 4 relativ zueinander sind in allen Ausführungsformen der Übertragungsglieder gemäß den FIG 9 bis 14 die Steuermittel 5 vorgesehen, die das wenigstens eine kapazitive Bauelement 23 jedes zu steuernde Übertragungsglieds entsprechend ansteuern.

Als kapazitives Bauelement 23 ist in allen Ausführungsformen der Verstärkereinrichtung 2 vorzugsweise jeweils eine Kapazitätsdiode vorgesehen, an die von den Steuermitteln 5 eine variable Sperrspannung als Steuerspannung anlegbar ist. Kapazitätsdioden haben präzis definierte Kennlinien ihrer Kapazität in Abhängigkeit von der angelegten Sperrspannung. Damit weisen die Verstärkereinrichtungen 2 unterschiedlicher Wandlerelemente 1 eines Arrays beispielsweise in einer Ausführungsform gemäß FIG 2 gute Gleichlaufeigenschaften auf.

In einer nicht dargestellten Ausführungsform kann als steuerbares kapazitives Bauelement 23 auch ein Normally-off-Feldeffekttransistor vorgesehen sein, an dessen Source-Drain-Strecke eine Steuerspannung angelegt wird und dessen Source und Gate elektrisch kurzgeschlossen sind. Die Kapazität zwischen Source und Drain wird über die Steuerspannung variiert.

Ein besonderer Vorteil einer kapazitiven Steuerung der Verstärkung der Verstärkereinrichtung 2 in einer der beschriebenen Ausführungsformen ist die geringe Verlustleistung einer solchen Steuerung.

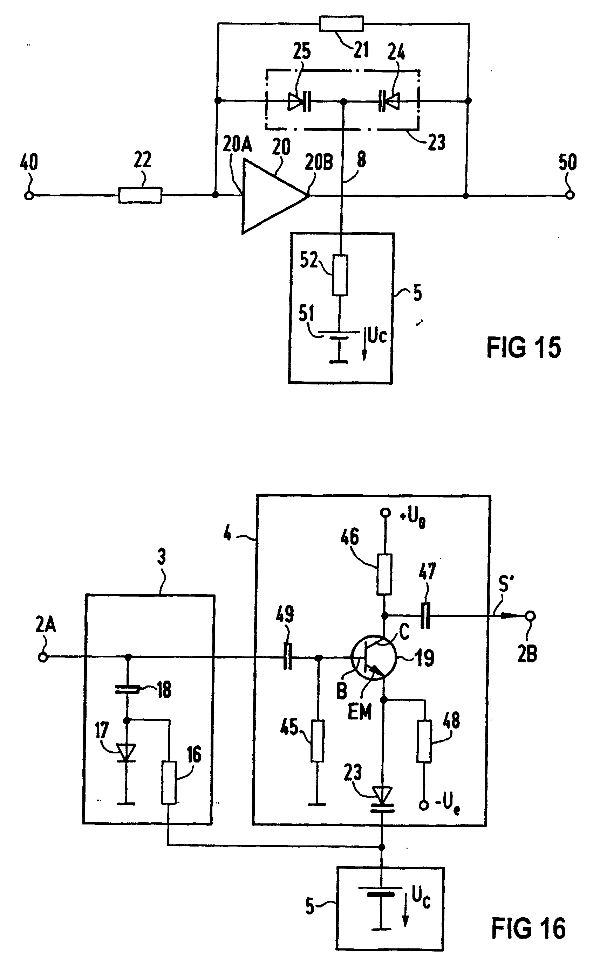

In der FIG 15 ist ein Ausführungsbeispiel eines Tiefpasses gemäß FIG 12 dargestellt, bei dem das steuerbare kapazitive Bauelement 23 zwei antiseriell geschaltete Kapazitätsdioden 24 und 25 umfaßt. Die Steuermittel 5 legen an die beiden Kapazitätsdioden 24 und 25 über eine beispielsweise elektrische Steuerleitung 8 in Sperrichtung eine Steuerspannung $U_C$ an. Die Steuermittel 5 enthalten dazu vorzugsweise einen Vorwiderstand 52 sowie eine Steuerspannungsquelle 51, die die Steuerspannung $U_C$ bereitstellt. Die Steuerspannung $U_C$ wird vorzugsweise so gewählt, daß über den vorgesehenen Aussteuerbereich des Verstärkers 20 keine der beiden Kapazitätsdioden 24 oder 25 leitend wird.

Um die Flanken beider Übertragungsglieder 3 und 4 wie in der Ausführungsform gemäß FIG 8 gemeinsam zu steuern, können die Steuermittel 5 eine für beide Übertragungsglieder 3 und 4 gemeinsam vorgesehene Steuerspannungsquelle enthalten, die mit den steuerbaren kapazitiven Bauelementen beider Übertragungsglieder 3 und 4 verbunden ist.

Die FIG 16 zeigt ein Ausführungsbeispiel einer Verstärkereinrichtung 2 mit den beiden Übertragungsgliedern 3 und 4 gemeinsamen Steuermitteln 5. Das erste Übertragungsglied 3 enthält einen Widerstand 16, eine pin-Diode 17 und eine Kapazität 18. Das zweite Übertragungsglied 4 enthält wenigstens einen bipolarer Transistor 19 als Verstärker und eine Gegenkopplungsschaltung für diesen wenigstens einen Verstärker, die wenigstens eine Kapazitätsdiode als steuerbares kapazitives Bauelement 23 enthält. Die Basis B des bipolaren Transistors 19 ist vorzugsweise über eine Kapazität 49 und über das erste Übertragungsglied 3 mit dem Eingang 2A der Verstärkereinrichtung 2 verbunden. Der Kollektor C des bipolaren Transistors 19 ist über eine Kapazität 47 mit dem Ausgang 2B der Verstärkereinrichtung 2 verbunden. Außerdem liegt am Kollektor C des bipolaren Transistors 19 über einen Vorwiderstand 46 eine positive Versorgungsspannung an. Am . Emitter EM des bipolaren Transistors 19 liegt dagegen über einen Vorwiderstand 48 eine negative Emitterspannung $-U_e$ an. Die Vorzeichen der beiden festen Spannungen $+U_0$ und $-U_e$ gelten für einen npn-Transistor 19 und sind natürlich zu vertauschen für.einen pnp-Transistor. In einer Emitterschaltung für den bipolaren Transistor 19 ist nun eine Kapazitätsdiode als steuerbares kapazitives Bauelement 23 zwischen den Emitter EM des bipolaren Transistors 19 und eine Steuerspannungsquelle als Steuermittel 5 geschaltet. Die Steuermittel 5 legen an die in Sperrichtung betriebene Kapazitätsdiode 23 eine Steuerspannung $U_C$ an zum Steuern der Kapazität der Kapazitätsdiode 23. Das Übertragungsglied 4 ist in seinem Frequenzverhalten ein Preemphasisglied. Seine somit positive Flanke kann durch Ändern der Steuerspannung $U_C$ verschoben werden. Zwischen Kapazität 49 und bipolaren Transistor 19 ist ein weiterer Widerstand 45 gegen Nullpotential geschaltet zum Festlegen des Basispotentials an der Basis B des Transistors 19. Die Steuermittel 5 sind auch mit dem ersten Übertragungsglied 3 verbunden. Die Steuerspannung $U_C$ wird über den Widerstand 16 auf einen Schaltungspunkt zwischen der pin-Diode 17 und der Kapazität 18 gelegt. Die Reihenschaltung aus Kapazität 18 und pin-Diode 17 ist zwischen den Eingang 2A der Verstärkereinrichtung 2 und Nullpotential geschaltet. Das erste Übertragungsglied 3 bildet zusammen mit dem Innenwiderstand des Wandlerelements 1 bezüglich seines Frequenzganges einen Tiefpaß. Der Widerstand der pin-Diode 17 ist durch die Steuerspannung $U_C$ der Steuermittel 5 steuerbar. Mit dem Widerstand der pin-Diode 17 ändert sich aber auch die Grenzfrequenz des mit dem ersten Übertragungsglied 3 gebildeten Tiefpasses. Durch Steuern der Steuerspannung $U_C$ kann deshalb außer der positiven Flanke des zweiten Übertragungsglieds 4 auch die negative Flanke des ersten Übertragungsglieds 3 verschoben werden.

Sowohl Kapazitätsdioden als auch pin-Dioden weisen gut reproduzierbare Kennlinien auf. Somit haben Verstärkereinrichtungen 2 in der Ausführungsform gemäß FIG 16 die für Arrays von Wandlerelementen 1 erforderlichen guten Gleichlaufeigenschaften. Die pin-Diode 17 wird zwar in Durchlaßrichtung betrieben, doch sind zum Steuern ihres Widerstands wegen des vergleichsweise hohen Innenwiderstands des Wandlerelements 1 nur relativ geringe Ströme von typischerweise weniger als 80 µA erforderlich. Die damit verbundene maximale Verlustleistung beträgt typischerweise nur einige 100 µW. Da durch das Übertragungsglied 3 mit der pin-Diode 17 die Empfangssignale S abgeschwächt werden, genügt für den gegengekoppelten bipolaren Transistor 19 bereits ein niedriger Ruhestrom von nicht mehr als 100 μA. Die Verlustleistung der gesamten Verstärkereinrichtung 2 ist deshalb sehr gering.

Mit der in FIG 16 gezeigten Ausführungsform kann eine Verstärkungsvariation gemäß FIG 8 realisiert werden. Die logarithmische Verstärkung A der Verstärkereinrichtung 2 ist maximal für eine verschwindende Steuerspannung $U_C = 0$ V. Die maximale Verstärkung A = $A_{max}$ ist durch die Impedanzen der einzelnen Schaltungselemente in den Übertragungsgliedern 3 und 4 festgelegt. Die minimale Verstärkung $A_{min}$ und damit die Aussteuerbarkeit und Dynamik der Verstärkereinrichtung 2 kann durch Einstellen der maximal anzulegenden Steuerspannung $U_C$ festgelegt werden.

Anstelle nur eines bipolaren Transistors 19 als Verstärker kann auch eine breitbandigere Kaskodeschaltung mehrerer bipolarer Transistoren vorgesehen sein.

Die Verstärkereinrichtung 2 kann in einer nicht dargestellten Ausführungsform auch nur ein zwischen Eingang 2A und Ausgang 2B geschaltetes Übertragungsglied 3 oder 4 in einer der vorbeschriebenen Ausführungsformen mit dem wenigstens einen kapazitiven Bauelement 23 enthalten. In dieser Ausführungsform der Verstärkereinrichtung 2 wird zwar auf eine Kompensation des Frequenzgangs der kapazitiven Steuerung der Verstärkung A* bzw. A im Wandlerkopf 9 verzichtet, doch kann dieser Frequenzgang auch von einer nachgeschalteten Signalverarbeitung korrigiert werden.

Als gegengekoppelte Verstärker können in allen Ausführungsformen der Verstärkereinrichtung 2 insbesondere bipolare Transistoren, Feldeffekttransistoren, insbesondere MOSFETs, oder auch integrierte Operationsverstärker verwendet werden. Diese drei Typen von Verstärkern sind besonders geeignet zur Integration mit einem Array von Wandlerelementen 1 im Wandlerkopf 9.

### Patentansprüche

**1.** Ultraschallwandlerkopf (9) mit

a) wenigstens einem Wandlerelement (1), das Ultraschallsignale empfängt und in elektrische Empfangssignale (S) umwandelt, und mit
b) einer Verstärkereinrichtung (2), die die Empfangssignale (S) des Wandlerelements (1) elektrisch verstärkt,
**dadurch gekennzeichnet, daß**
c) die Verstärkereinrichtung (2) wenigstens ein steuerbares kapazitives Bauelement (23,24,25) enthält und die Verstärkung (A*,A) der Verstärkereinrichtung (2) in Abhängigkeit von der Kapazität des kapazitiven Bauelements (23,24,25) steuerbar ist.

**2.** Ultraschallwandlerkopf nach Anspruch 1, bei dem die Verstärkereinrichtung (2)

a) wenigstens einen Verstärker (6,19,20) und
b) eine Gegenkopplungsschaltung mit dem steuerbaren kapazitiven Bauelement (23) für diesen wenigstens einen Verstärker (6,19,20) enthält.

**3.** Ultraschallwandlerkopf nach Anspruch 2, bei dem als Verstärker ein Feldeffekttransistor (6) vorgesehen ist, dessen Gate (CG) mit dem Wandlerelement (1) elektrisch verbunden ist und dessen Source (SC) mit dem wenigstens einen kapazitiven Bauelement (23) verbunden ist.

**4.** Ultraschallwandlerkopf nach Anspruch 2, bei dem als Verstärker ein bipolarer Transistor (19) vorgesehen ist, dessen Basis (B) mit dem Wandlerelement (1) verbunden ist und dessen Emitter (EM) mit dem wenigstens einen kapazitiven Bauelement (23) verbunden ist.

**5.** Ultraschallwandlerkopf nach einem der vorhergehenden Ansprüche, bei dem

a) die Verstärkereinrichtung (2) zwei zwischen einen Eingang (2A) für das Empfangssignal (S) und einen Ausgang (2B) für das verstärkte Empfangssignal (S') elektrisch in Reihe geschaltete Übertragungsglieder (3,4) enthält, die jeweils eine frequenzabhängige logarithmische Übertragungsfunktion (G,H) mit einer im wesentlichen linear von einer bijektiven Funktion (ν(f)) der Frequenz (f) abhängenden Flanke (E, F) aufweisen, wobei die Steigungen der beiden Flanken (E,F) der beiden Übertragungsfunktionen (G,H) im wesentlichen betragsmäßig gleich sind und unterschiedliche Vorzeichen aufweisen,
b) wenigstens eines der beiden Übertragungsglieder (3,4) das wenigstens eine steuerbare kapazitive Bauelement (23) enthält
c) und bei dem
d) die Flanken (E,F) der Übertragungsfunktionen (G,H) der beiden Übertragungsglieder (3,4) relativ zueinander innerhalb eines Frequenzbereichs (Δf) der Empfangssignale (S) verschiebbar sind.

**6.** Ultraschallwandlerkopf nach Anspruch 5, bei dem das Übertragungsglied (4), dessen Übertragungsfunktion (H) die Flanke (F) mit der positiven Steigung aufweist, einen Hochpaß wenigstens erster Ordnung, einen Differentiator und/oder ein Preemphasisglied enthält.

**7.** Ultraschallwandlerkopf nach Anspruch 5 oder Anspruch 6, bei dem das Übertragungsglied (3), dessen Übertragungsfunktion (G) die Flanke (E) mit der negativen Steigung aufweist, einen Tiefpaß wenigstens erster Ordnung, einen Integrator und/oder ein Deemphasisglied enthält.

8. Ultraschallwandlerkopf nach einem der Ansprüche 5 bis 7, bei dem jedes der beiden Übertragungsglieder (3,4) der Verstärkereinrichtung (2) wenigstens ein steuerbares kapazitives Bauelement (23,26) aufweist.

9. Ultraschallwandlerkopf nach einem der Ansprüche 2 bis 4 und einem der Ansprüche 5 bis 8, bei dem eines der beiden Übertragungsglieder (4) den wenigstens einen gegengekoppelten Verstärker (6,19,20) enthält und das andere Übertragungsglied (3) eine steuerbare pin-Diode (17) enthält.

10. Ultraschallwandlerkopf nach einem der vorhergehenden Ansprüche, bei dem das wenigstens eine kapazitive Bauelement eine Kapazitätsdiode (23,24,25) ist.

11. Ultraschallwandlerkopf nach einem der vorhergehenden Ansprüche mit einem zweidimensionalen Array von Wandlerelementen (1) und mit einer Verstärkereinrichtung (2) für jedes dieser Wandlerelemente (1).

12. Ultraschallgerät mit einem Ultraschallwandlerkopf (9) nach einem der vorhergehenden Ansprüche und mit Steuermitteln (5) zum Steuern der Kapazität (C) des wenigstens einen kapazitiven Bauelements (23) jeder Verstärkereinrichtung (2).

13. Ultraschallgerät nach Anspruch 12, bei dem

a) signalverarbeitende Mittel (31) zum Aufbau eines Bildes des Objekts aus den von der Verstärkereinrichtung (2) verstärkten Empfangssignalen (S') des wenigstens einen Wandlerelements (1) vorgesehen sind,
b) diese signalverarbeitenden Mittel (31) mit den Ausgängen (2B) der Verstärkereinrichtungen (2) im Ultraschallwandlerkopf (9) über Signalleitungen (34) verbunden sind und die
c) Ausgangsimpedanzen der Verstärkereinrichtungen (2) wenigstens annähernd den Impedanzen der zugehörigen Signalleitungen (34) angepaßt sind.

**Claims**

1. Ultrasound transducer head (9) having

a) at least one transducer element (1) which receives ultrasound signals and converts them into electrical received signals (S), and having
b) an amplifier device (2) which electrically amplifies the received signals (S) from the transducer element (1),
**characterized in that**
c) the amplifier device (2) contains at least one controllable capacitive component (23, 24, 25), and the gain (A*, A) of the amplifier device (2) can be controlled on the basis of the capacitance of the capacitive component (23, 24, 25).

2. Ultrasound transducer head according to Claim 1, in which the amplifier device (2) contains

a) at least one amplifier (6, 19, 20) and
b) a negative feedback circuit containing the controllable capacitive component (23) for this at least one amplifier (6, 19, 20).

3. Ultrasound transducer head according to Claim 2, in which the amplifier provided is a field-effect transistor (6) whose gate (CG) is electrically connected to the transducer element (1) and whose source (SC) is connected to the at least one capacitive component (23).

4. Ultrasound transducer head according to Claim 2, in which the amplifier provided is a bipolar transistor (19) whose base (B) is connected to the transducer element (1) and whose emitter (EM) is connected to the at least one capacitive component (23).

5. Ultrasound transducer head according to one of the preceding claims, in which

a) the amplifier device (2) contains two transfer elements (3, 4) which are electrically connected in series between an input (2A) for the received signal (S) and an output (2B) for the amplified received signal (S') and each have a frequency-dependent logarithmic transfer function (G, H) with an edge (E, F) which is essentially linearly dependent on a bijective function ($\nu$(f)) of the frequency (f), the gradients of the two edges (E, F) of the two transfer functions (G, H) being of essentially the same magnitude and having different arithmetic signs,
b) at least one of the two transfer elements (3, 4) contains the at least one controllable capacitive component (23),
c) and in which
d) the edges (E, F) of the transfer function (G, H) of the two transfer elements (3, 4) can be shifted relative to one another within a frequency range ($\Delta$f) of the received signals (S).

6. Ultrasound transducer head according to Claim 5, in which the transfer element (4) whose transfer function (H) has the edge (F) with the positive gradient contains a high-pass filter of at least first order, a differentiator and/or a pre-emphasis element.

7. Ultrasound transducer head according to Claim 5 or Claim 6, in which the transfer element (3) whose transfer function (G) has the edge (E) with the negative gradient contains a low-pass filter of at least first order, an integrator and/or a de-emphasis element.

8. Ultrasound transducer head according to one of Claims 5 to 7, in which each of the two transfer elements (3, 4) in the amplifier device (2) has at least one-controllable capacitive component (23, 26).

9. Ultrasound transducer head according to one of Claims 2 to 4 and one of Claims 5 to 8, in which one of the two transfer elements (4) contains the at least one amplifier (6, 19, 20) with negative feedback, and the other transfer element (3) contains a controllable pin diode (17).

10. Ultrasound transducer head according to one of the preceding claims, in which the at least one capacitive component is a capacitance diode (23, 24, 25).

11. Ultrasound transducer head according to one of the preceding claims, having a two-dimensional array of transducer elements (1) and having an amplifier device (2) for each of these transducer elements (1).

12. Ultrasound appliance having an ultrasound transducer head (9) according to one of the preceding claims and having control means (5) for controlling the capacitance (C) of the at least one capacitive component (23) in each amplifier device (2).

13. Ultrasound appliance according to Claim 12, in which

a) signal-processing means (31) are provided for constructing an image of the object from the received signals (S') from the at least one transducer element (1) which have been amplified by the amplifier device (2),
b) these signal-processing means (31) are connected to the outputs (2B) of the amplifier devices (2) in the ultrasound transducer head (9) via signal lines (34), and the
c) output impedances of the amplifier devices (2) are matched at least approximately to the impedances of the associated signal lines (34).

**Revendications**

1. Tête (9) de transducteur à ultrason comprenant

a) au moins un élément (1) transducteur qui reçoit des signaux d'ultrason et les transforme en signaux (S) électriques de réception et comprenant
(b) un dispositif (2) amplificateur qui amplifie électriquement les signaux (S) de réception de l'élément (1) transducteur
   **caractérisée en ce que**
c) le dispositif (2) amplificateur comporte au moins un composant (23, 24, 25) capacitif qui peut être commandé et le gain (A*, A) du dispositif (2) amplificateur peut être commandé en fonction de la capacité du composant (23, 24, 25) capacitif.

2. Tête de transducteur à ultrason suivant la revendication 1, dans laquelle le dispositif (2) amplificateur

a) comprend au moins un amplificateur (6, 19, 20) et
b) un circuit à contre-réaction avec le composant (23) capacitif qui peut être commandé pour ce au moins un amplificateur (6, 19, 20).

3. Tête de transducteur à ultrason suivant la revendication 2, dans laquelle il est prévu comme amplificateur un transistor (6) à effet de champ dont la grille (CG) est reliée électriquement à l'élément (1) transducteur et dont la source (SC) est reliée à le au moins un composant (23) capacitif.

4. Tête de transducteur à ultrason suivant la revendication 2, dans laquelle il est prévu comme amplificateur un transistor (19) bipolaire dont la base (B) est reliée à l'élément (1) transducteur et dont l'émetteur (EM) est relié à le au moins un composant (23) capacitif.

5. Tête de transducteur à ultrason suivant l'une des revendications précédentes, dans laquelle

a) le dispositif (2) amplificateur comprend deux éléments (3, 4) de transfert montés électriquement en série entre une entrée (2A) pour le signal (S) de réception et une sortie (2B) pour le signal (S') amplifié de réception, éléments qui ont respectivement une fonction (G,H) de transfert logarithmique en fonction de la fréquence ayant un front (E, F) dépendant de manière sensiblement linéaire d'une fonction (V(f)) bijective de la fréquence (f), les pentes des deux fronts (E, F) des deux fonctions ( G, H) de transfert étant sensiblement les mêmes en valeur absolue et ayant des signes différents

b) au moins l'un des deux éléments (3, 4) de transfert comportant le au moins un composant (3) capacitif qui peut être commandé

c) et dans laquelle

d) les fronts (E, F) des fonctions ( G, H) de transfert des deux éléments (3, 4) de transfert peuvent être déplacés l'un par rapport à l'autre dans un domaine (Δf) de fréquence du signal (S) de réception.

6. Tête de transducteur à ultrason suivant la revendication 5, dans laquelle l'élément (4) de transfert, dont la fonction ( H) de transfert a le front (F) ayant la pente positive, comporte un filtre passe-haut au moins du premier ordre, un différentiateur et/ou un organe de pré-accentuation.

7. Tête de transducteur à ultrason suivant la revendication 5 ou la revendication 6, dans laquelle l'élément (3) de transfert, dont la fonction ( G) de transfert a le front (E) ayant la pente négative, comprend un passe-bas au moins du premier ordre, un intégrateur et/ou un élément de désaccentuation.

8. Tête de transducteur à ultrason suivant l'une des revendications 5 à 7, dans laquelle chacun des deux éléments (3, 4) de transfert du dispositif (2) amplificateur a au moins un composant (23, 26) capacitif qui peut être commandé.

9. Tête de transducteur à ultrason suivant l'une des revendications 2 à 4 et l'une des revendications 5 à 8, dans laquelle l'un des deux éléments (4) de transfert comprend le au moins un amplificateur (6, 19, 20) à contre-réaction et l'autre élément (3) de transfert comprend une diode (17) de type pin qui peut être commandée.

10. Tête de transducteur à ultrason suivant l'une des revendications précédentes dans laquelle le au moins un composant capacitif est une diode (23, 24, 25) à capacité.

11. Tête de transducteur à ultrason suivant l'une des revendications précédentes, comprenant un réseau bidimensionnel d'éléments (1) transducteurs et un dispositif (2) amplificateur pour chacun de ces éléments (1) transducteurs.

12. Appareil à ultrason comprenant une tête (9) de transducteur d'ultrason selon l'une des revendications précédentes et des moyens (5) de commande destinés à commander la capacité (C) du au moins un composant (23) capacitif de chaque dispositif (2) amplificateur.

13. Appareil à ultrason suivant la revendication 12, dans lequel

a) il est prévu des moyens (31) de traitement du signal pour la constitution d'une image de l'objet à partir des signaux (S') de réception du au moins un élément transducteur, qui ont été amplifiés par le dispositif (2) amplificateur

b) ces moyens (31) de traitement du signal sont reliés aux sorties (2B) des dispositifs (2) amplificateurs de la tête (9) de transducteur à ultrason par des conducteurs (34) de signaux et

c) les impédances de sortie des dispositifs (2) amplificateurs sont adaptés au moins approximativement aux impédances des conducteurs (34) de signalisation associés.

FIG 1

FIG 3

FIG 2

S → 2A → [ 3 (G') ] →^{G' * S} [ 4 (H') 23 ] →^{S' = H' * G' * S} 2B

2

8

5

## FIG 4

$A$

$A_{max}$

$\Delta A$

$A_{min}$

$\Delta f$

$f_L$      $f_R$      $f$

10

## FIG 5

FIG 6

FIG 7

FIG 8

FIG 9

FIG 10

FIG 11

**FIG 12**

**FIG 13**

**FIG 14**

**FIG 15**

**FIG 16**